# EUROPEAN PATENT APPLICATION

(11) **EP 3 716 215 A1**
(43) Date of publication of application: **30.09.2020**
(21) Application number: 20163630.5
(22) Date of filing: 17.03.2020
(51) Int. Cl.: G06T 11/00, H01J 37/22

(54) **ARTIFICIAL INTELLIGENCE ENABLED VOLUME RECONSTRUCTION**

(30) Priority: 29.03.2019 US 201916369975
(71) Applicant: FEI Company, Hillsboro, OR 97124-5793 (US)
(72) Inventor: Poto ek, Pavel, 5602 BS Eindhoven (NL); Boughorbel, Faysal, 5602 BS Eindhoven (NL); Peemen, Maurice, 5602 BS Eindhoven (NL)
(74) Representative: Janssen, Francis-Paul

(57) **Abstract**

Methods and apparatuses for implementing artificial intelligence enabled volume reconstruction are disclosed herein. An example method at least includes acquiring a first plurality of multi-energy images of a surface of a sample, each image of the first plurality of multi-energy images obtained at a different beam energy, where each image of the first plurality of multi-energy images include data from a different depth within the sample, and reconstructing, by an artificial neural network, at least a volume of the sample based on the first plurality of multi-energy images, where a resolution of the reconstruction is greater than a resolution of the first plurality of multi-energy images.

## Description

### FIELD OF THE INVENTION

The invention relates generally to artificial intelligence (Al) enabled volume reconstruction, and specifically to artificial neural network enabled volume reconstruction for use in charged particle microscopy.

### BACKGROUND OF THE INVENTION

Volume reconstruction based on individually obtained images is implemented in a wide array of industries. For example, the life sciences industry uses volume reconstruction based on electron beam images to study tissue samples to gain insight into the workings of biological systems. While this process is widely used, the tools and current techniques are quite time consuming and/or computing intensive. The volumetric reconstruction techniques may take the form of array reconstruction where a sample is sliced into a large number of slices, which are then imaged with an SEM, for example. The SEM images may then become the basis of the reconstruction. This process, however, is time consuming and computational intensive. Another example includes imaging a sample surface, removing a slice of the sample, imaging, removing, and so on until the desired volume is imaged. This process is also time consuming and may induce sample damage due to the slice removal process used. Due to the issues with these processes, a faster process is desired.

### SUMMARY

An example method for implementing artificial intelligence enabled volume reconstruction may at least include acquiring a first plurality of multi-energy images of a surface of a sample, each image of the first plurality of multi-energy images obtained at a different beam energy, where each image of the first plurality of multi-energy images include data from a different depth within the sample, and reconstructing, by an artificial neural network, at least a volume of the sample based on the first plurality of multi-energy images, where a resolution of the reconstruction is greater than a resolution of the first plurality of multi-energy images.

In another embodiment, a system for implementing artificial intelligence enabled volume reconstruction may be a charged particle microscope system for obtaining volume reconstructions of a sample. The charged particle microscope system may at least include an electron beam for proving a beam of electrons at a plurality of different beam energies, a cutting tool for removing a slice of a sample, and a controller at least coupled to control the electron beam and the cutting tool. The controller may include or be coupled to a non-transitory computer readable medium storing code that, when executed by the controller or a computing system coupled to the controller, causes the system to acquire a first plurality of multi-energy images of a surface of a sample, each image of the first plurality of multi-energy images obtained at a different beam energy, where each image of the first plurality of multi-energy images include data from a different depth within the sample, and reconstruct, by an artificial neural network coupled to or included in the system, at least a volume of the sample based on the first plurality of multi-energy images, where a resolution of the reconstruction is greater than a resolution of the first plurality of multi-energy images.

In yet another example, a method is disclosed for implementing artificial intelligence enabled volume reconstruction at least includes receiving a plurality of multi-energy image data sets, each multi-energy data set of the plurality of multi-energy image data sets acquired of a different surface of a sample, wherein each multi-energy data set includes multiple images, each image of the multiple images acquired at a different beam energy, and where each image of the multiple images acquired include data from a different depth within the sample in relation to a respective surface of the different surfaces of the sample, and reconstructing, by an artificial neural network, a volume of the sample based on the plurality of multi-energy image data sets, where a resolution of the reconstruction is greater than a resolution of each image of the plurality of multi-energy image data sets.

### BRIEF DESCRIPTION OF THE DRAWINGS

Figure 1 is an example of a charged particle microscope system in accordance with an embodiment of the present disclosure.
Figures 2 is an example method for obtaining a high resolution reconstruction of a volume of a sample based on lower resolution multi-energy image data in accordance with an embodiment of the present disclosure.
Figure 3 is an example method for training an artificial neural network in accordance with an embodiment of the present disclosure.
Figure 4A is an example illustration of training a 3D ANN for volume reconstruction in accordance with an embodiment of the present disclosure.
Figure 4B illustrates the physical/size differences between ME image data and FIB-based slice and view data.
Figures 5 is a block diagram that illustrates a computer system 500 upon which an embodiment of the invention may be implemented.

Like reference numerals refer to corresponding parts throughout the several views of the drawings.

### DETAILED DESCRIPTION OF EMBODIMENTS

Embodiments of the present invention relate to Artificial Intelligence (Al) enhanced volume reconstruction. In some examples, the AI aspect assists in reconstructing a volume of a sample based on sparse/low resolution data that results in a reconstruction at a higher resolution. For example, multi-energy images may be acquired of a number of surfaces of a sample (the surfaces sequentially exposed due to material removal) and the multi-energy images are provided to an artificial neural network that reconstructs the volume, where the reconstructed volume has the resolution of a focused ion beam based slice and view data set of the same sample volume. However, it should be understood that the methods described herein are generally applicable to a wide range of different AI enhanced reconstruction techniques.

As used in this application and in the claims, the singular forms "a," "an," and "the" include the plural forms unless the context clearly dictates otherwise. Additionally, the term "includes" means "comprises." Further, the term "coupled" does not exclude the presence of intermediate elements between the coupled items. Additionally, in the following discussion and in the claims, the terms "including" and "comprising" are used in an open-ended fashion, and thus should be interpreted to mean "including, but not limited to ...." Additionally, the term multi-energy images, or set of multi-energy images, or (set of) multi-energy image data includes data from two, three or more images acquired of a same surface of a sample where each image of the (set of) multi-energy images is acquired at a different charged particle beam landing energy. The changes/difference in landing energy between the images in a set of multi-energy images includes data from different depths within the sample that will also include some data overlap between the images. Further, the higher the landing energy of the charged particle beam, the deeper the charged particles will penetrate into the sample resulting in data obtain from deeper within the sample. This data obtained at different depths gives some indication of the sample material at those depths.

The systems, apparatus, and methods described herein should not be constructed as limiting in any way. Instead, the present disclosure is directed toward all novel and non-obvious features and aspects of the various disclosed embodiments, alone and in various combinations and sub-combinations with one another. The disclosed systems, methods, and apparatus are not limited to any specific aspect or feature or combinations thereof, nor do the disclosed systems, methods, and apparatus require that any one or more specific advantages be present or problems be solved. Any theories of operation are to facilitate explanation, but the disclosed systems, methods, and apparatus are not limited to such theories of operation.

Although the operations of some of the disclosed methods are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed systems, methods, and apparatus can be used in conjunction with other systems, methods, and apparatus. Additionally, the description sometimes uses terms like "produce" and "provide" to describe the disclosed methods. These terms are high-level abstractions of the actual operations that are performed. The actual operations that correspond to these terms will vary depending on the particular implementation and are readily discernible by one of ordinary skill in the art.

In general, forming volume reconstructions from individual slices of a sample can include blurriness and inaccuracies when the thickness of each slice is thicker than the data can accurately provide. For example, if a voxel (3D pixel characterization of the volume reconstruction) is 10 nm by 10 nm in the x and y dimensions but is 30 to 50 nm in the z direction, the anisotropic size of the voxel tends to provide results that are less than reliable. In this example, the x and y coordinate directions of the voxel are based on pixel scan sizes of a charged particle beam system, while the z dimension is determined on the technique used to remove a slice of the sample. Additionally, the anisotropy of the voxels are at least partially due to the physical limitation of the mechanical slicers conventionally used to remove each slice, where the physical slicers, e.g., microtomes, are not able to reliably cut 10nm thick slices. More typically, the mechanical slicers can provide only 20 to 50 nm slice thicknesses. Industrial use of such volume reconstruction techniques, such as the life science industry, is preferable to obtain isotropic voxels, which provide better resolution and analytical abilities.

While solutions to this problem do exist, such as the use of focused ion beam (FIB) milling to remove thin layers that are imaged or deconvolution algorithms to use with multi-energy imaging techniques, such solutions have their own inherent problems. For instance, FIB-based milling and imaging, also referred to as slice and view, can be an extremely time involved process and further includes the potential for sample damage due to the ion beam, especially considering soft biological samples. The deconvolution solution, while may not include sample damage, results in time consuming computational time as well as limits on resolution of areas of the volume that do not have an exact associated image, i.e., areas having been interpolated through the deconvolution computation. See U.S. Pat. No. 8,586,921 B2, entitled "Charged-Particle Microscope Providing Depth-Resolved Imagery," assigned to the present assignee, for an example of a deconvolution solution as discussed herein. A note about multi-energy (ME) imaging techniques: The multi-energy technique involves taking images of a surface at different energies (e.g., 800V to 5kV (but typically a smaller range)) where the different energies provides data from different depths within the sample. Then, a slice of the sample is removed, typically 30 to 50 nm, and the images at the different energies are acquired again. This is done for a desired volume and the images of the various surfaces at the various energies are then deconvolved to provide data of the entire volume. As can be seen, information of the entire volume is not directly acquired, but can be interpolated from the various images due to overlap between images take from adjacent slices. As can be seen, a faster less computational approach is desired to speed up analysis of samples.

One solution to this problem is to use artificial intelligence (Al), such as with an artificial neural network (ANN), to produce the volume reconstructions having isotropic voxels from ME data. While the ME data may be somewhat sparse in some ways, it is quicker to obtain than FIB-based slice and view data and less prone to sample damage. Further, the ANN may be trained using ME data and FIB-based data of the same volume. For example, the ANN can be trained using the ME data and the training model may be adjusted based on a comparison of FIB-based data and reconstructions based on the ME data. Once trained, however, the ANN may more quickly provide a volume reconstruction of a new set of ME volume data than either the FIB-based technique or the ME deconvolution technique, and at a resolution equal to that obtained through FIB slice and view techniques.

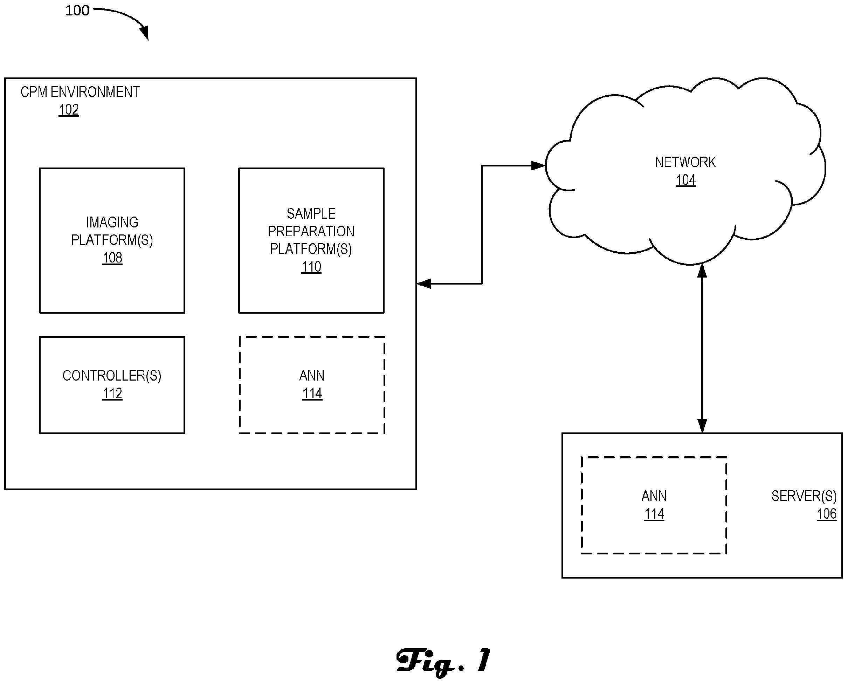

Figure 1 is an example of a charged particle microscope system 100 in accordance with an embodiment of the present disclosure. The charged particle microscope (CPM) system 100, or simply system 100, at least includes a CPM environment 102, a network 104, one or more servers 106, and an artificial neural network 114. The CPM system 100 may be used to investigate and analyze samples of various size and makeup. For one example, the CPM system 100 may be implemented, at least partially, at an industrial or research location and used to analyze various aspects of biological samples. Of course, other types of samples may also be analyzed, such as mineral, metal alloys, semiconductor, etc. In some embodiments, the CPM system 100 may be distributed across various locations. For example, the CPM environment 102 may be located at a research location, the network 104 distributed locally, regionally, or nationally, and the server 106 located at a server farm and coupled to the CPM environment 100 via the network 104. Regardless of the organization of the CPM system 100, the system 100 may at least be used to implement one or more artificial neural networks (ANN) 114 along to perform various volume reconstruction tasks.

The CPM environment 102 includes any type of charged particle microscope, but the application of the neural network disclosed herein is not limited to charged particle microscopy, which is used for illustrative purposes only. Example CPMs include scanning electron microscopes (SEMs), transmission electron microscopes (TEMs), scanning transmission electron microscopes (STEMs), focused ion beams (FIBs), and dual beam (DB) systems that include both electron and ion beam capabilities, to name a few. The CPM environment 102 may be used to obtain electron or ion images of samples, some of which may include multiple images obtained at various energies of different surfaces of the sample, the different surfaces being exposed through removal of layers of the sample. The CPM environment 102 may include various aspects that can be contained in a single tool or that may be situated in separate tools. For example, the CPM environment 102 may include an imaging platform 108, e.g., an SEM, TEM, or STEM, a sample preparation platform 110, and one or more controllers 112. Of course, each platform 108 and 110 may include more than one microscope/sample preparation tools as well.

The imaging platform 108 is used to obtain images of samples, some of the samples may have been prepared by the sample prep platform 110, but that is not necessary. The images are obtained using an electron and/or ion source to irradiate the sample with a respective beam of charged particles. In some examples, the charged particle beam imaging is obtained by a scanned beam, e.g., moved across the sample, while other examples the charged particle beam is not scanned. Backscattered, secondary, or transmitted electrons, for example, are then detected and gray scale images formed based thereon. With regards to the present disclosure, the images obtained to be used in the reconstruction process are obtained using backscattered electrons. The images include gray scale contrast depending on the materials of the sample, where the changes in gray scale indicate changes in the material type or crystal orientation. Additionally, the imaging platform 108 may obtain images at various charged particle beam energies based on one or more control signals. The imaging platform 108 may be controlled by internal controls (not shown), controller 112, or a combination thereof.

The sample prep platform 110 forms some of the samples that are imaged by the imaging platform 108. Of course, imaged samples may also be formed by other tools (not shown). The sample prep 110 may, for example, be a DB system that uses a FIB column to prepare and assist in the removal of a layer of a sample, such as by ion milling, ion induced etching, or a combination thereof. The sample prep platform 110 may also include an electron beam imaging component that allows the sample prep process to be monitored, but the electron beam imaging component is not required. Similar to the imaging platform 108, the electron beam imaging component of the sample prep platform 110 may be able to obtain images at different electron beam energies. In some embodiments, the sample prep platform 110 may also include other physical preparation aspects, such as lasers and physical cutting tools (e.g., a knife edge or a microtome), etc., that are used to prepare the sample for the imaging platform 108. The sample prep platform 110 may be controlled by internal controls (not shown), controller 112, or a combination thereof.

The network 104 may be any kind of network for transmitting signals between the CPM environment 102 and the server(s) 106. For example, the network 104 may be a local area network, a large area network, or a distributive network, such as the internet, a telephony backbone, and combinations thereof.

The servers 106 may include one or more computing platforms, virtual and/or physical, that can run code for various algorithms, neural networks, and analytical suites. While not shown, a user of the CPM environment 102 may have access to the servers 106 for retrieval of data, updating software code, performing analytical tasks on data, etc., where the access is through the network 104 from the user's local computing environment (not shown). In some embodiments, the user accesses image data stored on the servers 106, implements volume reconstruction using the ANN 114 (which may be executed on the servers 106 or the CPM Environment 102).

In operation, a number of ME images may be obtained of each surface of a sequential series of surfaces of a sample. Each of the ME images for each surface may be obtained at different electron beam energies, and each surface may be imaged at the same electron beam energies. For example, two or more images of a surface may be obtained at a respective electron beam energy, e.g., 800V, 1.5kV, 2kV, etc. In general, the range of electron beam energies may be from 800V to 5kV, but the energies used may depend on the robustness of the sample. For example, a biological sample may desiredly be imaged at lower energies to limit sample degradation, whereas a harder sample, e.g., minerals or alloys, may be imaged at higher energies. Acquiring multiple ME images of a surface, information about a volume of the sample with respect to that surface is obtained. In general, each acquisition of an image at an increased beam energy results in the charged particle, e.g., electrons, entering deeper into the specimen, which further results in the mixing of the depth signals of the separate ME images. Higher energies cover a broader depth, so the successive energies should be deconvolved to ob-tain the depth information.

An ME imaging sequence to obtain a plurality of sets of ME data for a reconstruction may involve sequentially imaging a series of surfaces exposed through removal of sample material. For example, a set of images of a first are acquired where each image of the set (two, three or more images in the set) are acquired at a different charged particle beam energy with higher beam energies providing information from deeper within the sample. For instance, a first image may be acquired at 1kV, a second image at 1.8kV, and a third image acquired at 2.4kV to form a set of ME images/image data. Once the ME images of the set are acquired, a slice of the sample is removed to expose a subsequent surface and the ME image acquisition process is repeated. In this example, the slice is removed using a knife edge or a microtome, which may result in the removal of 30 to 50 nm of material. It should be noted that the charged particle imaging includes rastering a charged particle beam across an area of the surface with an x and y pixel size, as noted above, determining an x and y size of a voxel. The x, y scan size may result in pixels of 10 nm by 10 nm, for example. It should also be noted that, depending on the beam energy, the high energy ME images may obtain information beyond a slice thickness so that there is overlap in data between sequential sets of ME images. Further, there is also overlap in data between images within each set of ME images. This ME imaging and slice removal process is repeated until a desired volume of the sample is imaged.

After acquisition of a desired number of ME images, which may be from a single slice to a plurality of slices, such as 4, 10, 20, etc., (the number of slices is a non-limiting aspect of the present disclosure) the ANN 114 is provided all the ME images to generate a reconstruction of the imaged volume of the sample. The reconstruction, however, will have higher resolution than the ME image data. Additionally, a voxel size of the reconstruction will be isotropic, e.g., will have the same size in all three dimensions, even though the base data, i.e., the ME image data, does not have such isotropy in voxel size. In some embodiments, the ANN 114 included in CPM environment 102 performs the reconstruction upon being provided the ME images. In other embodiments, the ME images are stored on server(s) 106, and then accessed at some other time to perform the reconstruction using ANN 114 included with server(s) 114. Of course, the ME images may be provided to a user with access to the network 104, which then implements an instance of ANN 114 to perform the reconstruction. It should be noted that all embodiments are contemplated herein and the reconstruction is not necessarily performed on CPM environment 102.

While the image provided to the ANN 114 is described as being obtained by imaging platform 108, in other embodiments, the image may be provided by a different imaging platform and provided to the ANN 114 via the network 104.

In one or more embodiments, the ANN 114, which may also be referred to as a deep learning system, may be a three-dimensional artificial neural network capable of handling volume data. Of course, two-dimensional ANNs capable of handling volumetric data may also be implemented and are contemplated herein. The ANN 114 includes a collection of connected units or nodes, which are called artificial neurons. Each connection transmits a signal from one artificial neuron to another. Artificial neurons may be aggregated into layers. Different layers may perform different kinds of transformations on their inputs.

One type of ANN 114 is a convolutional neural network (CNN). A CNN is conventionally designed to process data that come in the form of multiple arrays, such as a color image composed of three two-dimensional arrays containing pixel intensities in three color channels. Example architecture of a CNN is structured as a series of stages. The first few stages may be composed of two types of layers: convolutional layers and pooling layers. A convolutional layer applies a convolution operation to the input, passing the result to the next layer. The convolution emulates the response of an individual neuron to visual stimuli. A pooling layer combines the outputs of neuron clusters at one layer into a single neuron in the next layer. For example, max pooling uses the maximum value from each of a cluster of neurons at the prior layer.

In one or more embodiments, the ANN 114 is a 3D CNN configured to reconstruct volumes based on a plurality of 2D images, such as ME images. Other examples of 3D ANNs includes multi-scale CNNs, 3D U-net, fully convolutional network (FCN), Super-Resolution 3D Generative Adversarial Networks (SRGANs), One Binary Extremely Large and Inflecting Sparse Kernel (OBELISK) base network, Point Set Prediction Network (PSPN), VoxNet, and PointGrid, to name a few. Of course, the list of potential 3D ANNs is not exhaustive and future developed 3D ANNs are also contemplated herein. In some embodiments, a combination of the enumerated or future 3D neural networks may be implemented. To use the 3D context information 3D convolution operations should be used. This step changes a normal Convolutional Network into a 3D Convolutional Network. The result of these 3D convolutions is a volume. In general, the 2d inputs/outputs along with the convolution and max pooling layers are changed from 2D to 3D variants. However, while these different layers are discussed as being 3D, the inner network layers may contain an n x, y, z, and a featuremap dimension, which makes it a total of 4 dimensions. At the output all the information is pruned back to the 3D volume with the same size as the input.

In other embodiments, the ANN 114 may include one or more 2D artificial neural networks, such as a CNN or FCN, that may be trained to provide 3D volumetric reconstructions in combination. For example, one artificial neural network may be trained to use one dimension of the ME image data, the x-dimension for example a second neural network trained to use a different dimension of the ME image data, the y-dimension for example, and a third the remaining dimension of the ME image data, the z-dimension for example. Each of those three neural networks would then provide associated outputs that would be combined to provide the 3D volumetric reconstruction. In some embodiments, a 2D CNN could also be used to combine the dimensional outputs. In general, the ME image data may be broken down into various number of dimensions (two dimensions, three dimension, etc.) with each dimension provided to a separate ANN to provide a respective reconstructed output, which would then be provided to a subsequent ANN to combine into a volume reconstruction.

In yet another embodiment, two ANNs 114 may be used to reconstruct x and y components of the ME image data, which is then provided to a third ANN to combine into the volumetric reconstruction. For example, a 2D ANN may receive ME image data along a number of pixels in an x-direction and provide a reconstruction along that direction, and a second 2D ANN may receive ME image data along a number of pixels in a y-directin and provide reconstruction along that direction. The two reconstructions may then be combined by another 2D ANN to provide the volumetric reconstruction.

Prior to use, the ANN 114 may need to be trained to identify desired features of structure in an image. Stated another way, the ANN 114 needs to learn how to reconstruct volumes from relatively sparse ME image data sets. The training may typically include providing the ANN 114 a number of annotated ME images of one or more samples with the annotations highlighting the quality or weight of the image. Based on the training images, the ANN 114 learns how reconstruct volumes based thereon. Further, the training of the ANN 114 for volume reconstruction may further be refined through comparison of volume reconstructions generated based on ME image data to FIB slice and view data of the same volume. For example, a set ME images may be labeled and used for training the ANN 114. To validate the training, the ANN 114 may then generate a reconstruction using the same unlabeled data. This reconstruction may then be compared to FIB slice and view data of the same volume of sample. The comparison, or difference, may then be used to update the ANN 114, such as by adjusting weights assigned to nodes of the ANN 114.

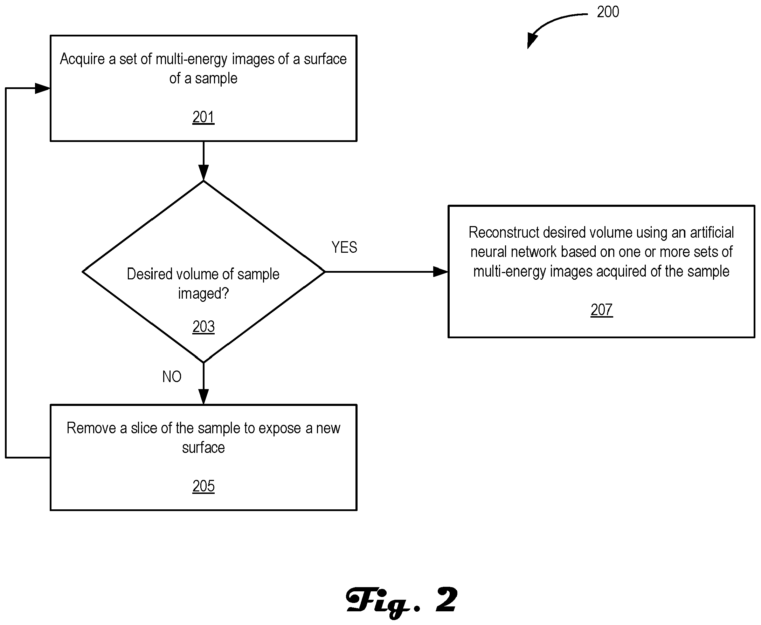

Figure 2 is an example method 200 for obtaining a high resolution reconstruction of a volume of a sample based on lower resolution multi-energy image data in accordance with an embodiment of the present disclosure. The method 200 may be implemented by a charged particle microscope system, such as the system 100, or by a standalone ANN coupled to receive multi-energy image data of a volume of a sample. In either embodiment, the multi-energy image data of a volume of a sample may be the basis of a reconstruction of that volume, the reconstruction formed by the receiving ANN.

The method 200 may begin at process block 201, which includes acquiring a set of multi-energy images of a surface of a sample. The set of multi-energy images of the surface may include two, three or more images obtained of the surface where each image is obtained at a different electron beam energy. For example, a first multi-energy image of the set of images may be obtained at 1kV, whereas a second image may be obtained at an energy greater than or less than 1kV. If a third image is obtained, then the respective beam energy will be different than that used for the first and second images.

The process block 201 may be followed by process block 203, which includes determining whether a desired volume of the sample has been imaged. If the determination is yes, then process block 207 follows, else process block 205 follows.

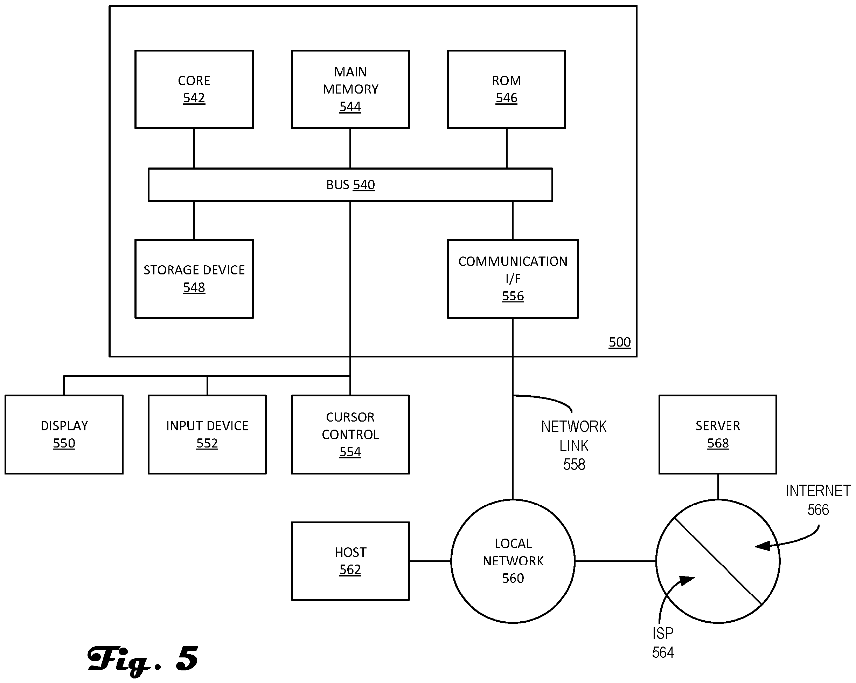

The process block 205 includes removing a slice of the sample to expose a new surface. The slice may be removed by any tool available in a charged particle microscope, such as by a microtome, a knife edge, an ion beam (focused or broad beam), to name a few. If the sample is a biological sample, then the microtome or knife edge may be the desired tool for slice removal to avoid sample damage. In general, the removed slice may be 30 to 50 nanometers thickness. This thickness may be compared to the imaging depth of the previous set of multi-energy images acquired. Due to obtaining the set of images at different energies, the images contain information from different depths into the sample, which may be deeper than the thickness of the removed slice. As such, sequential multi-energy image data sets may include overlapping data, see Figure 5 for example.

In some embodiments, the process blocks 201 and 205 may be sequentially repeated until a desired volume of the sample is imaged. However, in some embodiments, this may only include a single set of ME images.

Once it has been determined that the desired volume of the sample has been imaged, process block 207 is performed. Process block 207 at least includes reconstructing the volume of the sample using an artificial neural network based on one or more sets of multi-energy images acquired of the sample. The one or more sets depends on how may sets of data and slices are removed from the sample. In some embodiments, the artificial neural network may be a 3D ANN, such as 3D U-net or a 3D CNN to name a couple examples. In other embodiments, the artificial neural network includes a plurality of 2D ANNs, where the ME images are broken into a number of separate coordinate dimensions, x, y and z for example, and each coordinate direction is provide a different 2D ANN for providing an associated reconstruction. Once the individual coordinate reconstructions are performed, another 2D ANN receives the coordinate reconstructions and reconstructs the volumetric data based thereon. The reconstructed volume may have a higher resolution than the resolution of the multi-energy images due to the Al-based reconstruction. In some embodiments, the reconstruction may have a resolution equal to that if the images were obtain through a FIB-based slice and view process, which results in voxels of about 10nmx10nmx10nm. For comparison, non AI-based reconstructions that use the multi-energy data may have a voxel size with a z-coordinated based on the slice thickness, e.g., 30 to 50 nm. It should be noted that a deconvolution technique as referenced above may obtain similar resolution as presented in the current disclosure but using a different mathematical algorithm.

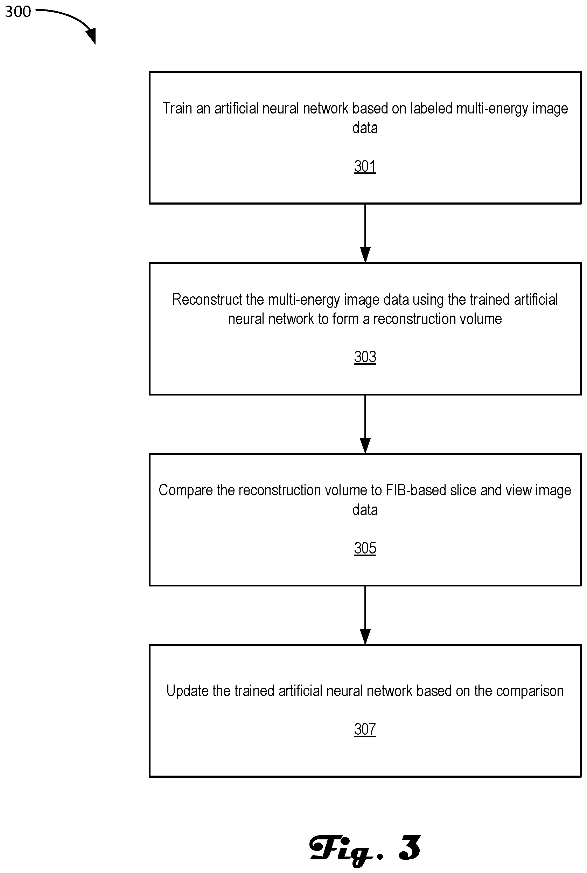

Figure 3 is an example method 300 for training an artificial neural network in accordance with an embodiment of the present disclosure. The method 300 may be performed by any computing system, and does not necessarily need to be performed by a charged particle microscope system. However, the data used to train the ANN by method 300 should be obtained by a charged particle microscope system, such as the system 100. The method 300 uses two different sets of data obtained of the same volume of a sample to train the ANN. By using different data of the same volume of a sample, the output of the ANN can be compared to a known set of data and a difference between the data can be used to adjust the training model and/or the nodes of the ANN.

The method 300 may begin at process block 301, which includes training an artificial neural network based on labeled multi-energy image data. The labeling may be performed by a skilled technician, or, in some embodiments, by another neural network trained to provide such labeling. The labeling may include classifications, annotations, weights and/or quality values assigned to each image or parts of an image. The ME image training data used in process block 301 may be of the same sample, e.g., data from process block 201 of method 200, or of a large number of different samples and associated ME training image data.

The process block 301 may be followed by process block 303, which includes reconstructing the multi-energy data using the trained artificial neural network to form a reconstruction volume. The multi-energy data used here may be the same data that was used to train the network only the labels will be absent. The output will consist of a reconstruction of the same volume of sample.

The process block 303 may be followed by process block 305, which includes comparing the reconstruction volume to high resolution volumetric data of the same volume of the sample. For example, FIB-based slice and view image data may be used in process block 305. The comparison results in a difference between the multi-energy based reconstruction and the FIB-based slice and view data, and this difference is provided to the ANN to update the ANN coefficients (process block 307).

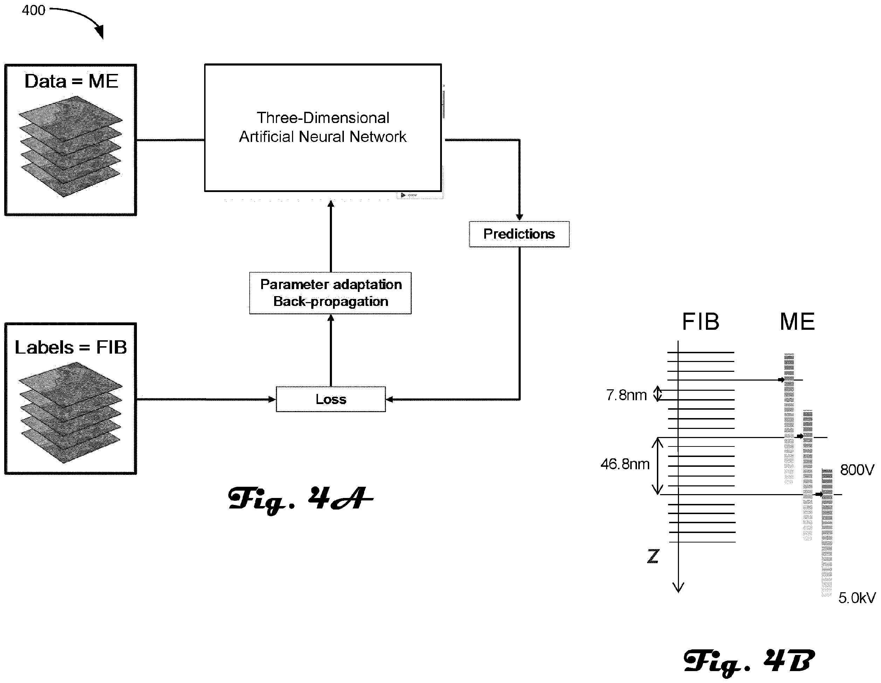

Figure 4A is an example illustration 400 of training a 3D ANN for volume reconstruction in accordance with an embodiment of the present disclosure. The illustration 400 is analogous to the method 300 disclosed above. The illustration shows the workflow and associated images used to train a 3D ANN as disclosed herein. For example, a set of ME image data is provided to the 3D ANN to form a volume reconstruction based thereon. The 3D ANN in this example has already been trained with labeled images of the same set of ME image data. The reconstruction, indicated as "Predictions" in Figure 4A, are then compared to labeled FIB data of the same volume of the same sample. This comparison is indicated as "Loss" in Figure 4A.

Figure 4B illustrates the physical/size differences between ME image data and FIB-based slice and view data. On the left side of Figure 4B, the FIB-based slice and view data is illustrated as being 7.8 nm thick, which provides data every 7.8 nm and is conventionally high resolution data based on imaging characteristics (dwell time, beam energy, etc.). In comparison, the ME image data is shown on the right to include somewhat of a continuum of data based on beam energy that is roundly 40 to 50 nm thick. The overall depth of the ME data is based on the beam energies used for the imaging and the scale shown may be the largest target range in most applications, but other ranges may be implemented. As can be seen, the FIB-based data provides high resolution data for very small increments of a sample, whereas the ME image data provides more sparse data for larger volumes of the sample.

Returning to Figure 4A, the comparison of the FIB-based data to the Predictions (e.g., reconstruction) provides insight into how well the 3D ANN did in generating the Predictions. And, because the FIB-based data is of the same volume of the same sample, the Loss information may be directly used to update the 3D ANN. The update of the 3D ANN may be implemented, for example through Parameter adaptation back projection. Of course, any method for training or retraining the 3D ANN may be used.

According to one embodiment, the techniques described herein are implemented by one or more special-purpose computing devices. The special-purpose computing devices may be hard-wired to perform the techniques, or may include digital electronic devices such as one or more application-specific integrated circuits (ASICs), field programmable gate arrays (FPGAs), or network processing units (NPUs) that are persistently programmed to perform the techniques, or may include one or more general purpose hardware processors or graphics processing units (GPUs) programmed to perform the techniques pursuant to program instructions in firmware, memory, other storage, or a combination. Such special-purpose computing devices may also combine custom hard-wired logic, ASICs, FPGAs, or NPUs with custom programming to accomplish the techniques. The special-purpose computing devices may be desktop computer systems, portable computer systems, handheld devices, networking devices or any other device that incorporates hard-wired and/or program logic to implement the techniques.

For example, Figure 5 is a block diagram that illustrates a computer system 500 upon which an embodiment of the invention may be implemented. The computing system 500 may be an example of the computing hardware included with CPM environment 102, such a controller 112, imaging platform 108, sample preparation platform 110, and/or servers 106. Additionally, computer system 500 may be used to implement the one or more neural networks disclosed herein, such as ANN 114 and/or CNNs 214A-D. Computer system 500 at least includes a bus 540 or other communication mechanism for communicating information, and a hardware processor 542 coupled with bus 540 for processing information. Hardware processor 542 may be, for example, a general purpose microprocessor. The computing system 500 may be used to implement the methods and techniques disclosed herein, such as methods 301 and 401, and may also be used to obtain images and segment said images with one or more classes.

Computer system 500 also includes a main memory 544, such as a random access memory (RAM) or other dynamic storage device, coupled to bus 540 for storing information and instructions to be executed by processor 542. Main memory 544 also may be used for storing temporary variables or other intermediate information during execution of instructions to be executed by processor 542. Such instructions, when stored in non-transitory storage media accessible to processor 542, render computer system 500 into a special-purpose machine that is customized to perform the operations specified in the instructions.

Computer system 500 further includes a read only memory (ROM) 546 or other static storage device coupled to bus 540 for storing static information and instructions for processor 542. A storage device 548, such as a magnetic disk or optical disk, is provided and coupled to bus 540 for storing information and instructions.

Computer system 500 may be coupled via bus 540 to a display 550, such as a cathode ray tube (CRT), for displaying information to a computer user. An input device 552, including alphanumeric and other keys, is coupled to bus 540 for communicating information and command selections to processor 542. Another type of user input device is cursor control 554, such as a mouse, a trackball, or cursor direction keys for communicating direction information and command selections to processor 542 and for controlling cursor movement on display 550. This input device typically has two degrees of freedom in two axes, a first axis (e.g., x) and a second axis (e.g., y), that allows the device to specify positions in a plane.

Computer system 500 may implement the techniques described herein using customized hard-wired logic, one or more ASICs or FPGAs, firmware and/or program logic which in combination with the computer system causes or programs computer system 500 to be a special-purpose machine. According to one embodiment, the techniques herein are performed by computer system 500 in response to processor 542 executing one or more sequences of one or more instructions contained in main memory 544. Such instructions may be read into main memory 544 from another storage medium, such as storage device 548. Execution of the sequences of instructions contained in main memory 544 causes processor 542 to perform the process steps described herein. In alternative embodiments, hard-wired circuitry may be used in place of or in combination with software instructions.

The term "storage media" as used herein refers to any non-transitory media that store data and/or instructions that cause a machine to operate in a specific fashion. Such storage media may comprise non-volatile media and/or volatile media. Non-volatile media includes, for example, optical or magnetic disks, such as storage device 548. Volatile media includes dynamic memory, such as main memory 544. Common forms of storage media include, for example, a floppy disk, a flexible disk, hard disk, solid state drive, magnetic tape, or any other magnetic data storage medium, a CD-ROM, any other optical data storage medium, any physical medium with patterns of holes, a RAM, a PROM, and EPROM, a FLASH-EPROM, NVRAM, any other memory chip or cartridge, content-addressable memory (CAM), and ternary content-addressable memory (TCAM).

Storage media is distinct from but may be used in conjunction with transmission media. Transmission media participates in transferring information between storage media. For example, transmission media includes coaxial cables, copper wire and fiber optics, including the wires that comprise bus 540. Transmission media can also take the form of acoustic or light waves, such as those generated during radio-wave and infra-red data communications.

Various forms of media may be involved in carrying one or more sequences of one or more instructions to processor 542 for execution. For example, the instructions may initially be carried on a magnetic disk or solid state drive of a remote computer. The remote computer can load the instructions into its dynamic memory and send the instructions over a telephone line using a modem. A modem local to computer system 500 can receive the data on the telephone line and use an infra-red transmitter to convert the data to an infra-red signal. An infra-red detector can receive the data carried in the infra-red signal and appropriate circuitry can place the data on bus 540. Bus 540 carries the data to main memory 544, from which processor 542 retrieves and executes the instructions. The instructions received by main memory 544 may optionally be stored on storage device 548 either before or after execution by processor 542.

Computer system 500 also includes a communication interface 556 coupled to bus 540. Communication interface 556 provides a two-way data communication coupling to a network link 558 that is connected to a local network 560. For example, communication interface 556 may be an integrated services digital network (ISDN) card, cable modem, satellite modem, or a modem to provide a data communication connection to a corresponding type of telephone line. As another example, communication interface 556 may be a local area network (LAN) card to provide a data communication connection to a compatible LAN. Wireless links may also be implemented. In any such implementation, communication interface 556 sends and receives electrical, electromagnetic or optical signals that carry digital data streams representing various types of information.

Network link 558 typically provides data communication through one or more networks to other data devices. For example, network link 558 may provide a connection through local network 560 to a host computer 562 or to data equipment operated by an Internet Service Provider (ISP) 564. ISP 564 in turn provides data communication services through the world wide packet data communication network now commonly referred to as the "Internet" 566. Local network 560 and Internet 566 both use electrical, electromagnetic or optical signals that carry digital data streams. The signals through the various networks and the signals on network link 558 and through communication interface 556, which carry the digital data to and from computer system 500, are example forms of transmission media.

Computer system 500 can send messages and receive data, including program code, through the network(s), network link 558 and communication interface 556. In the Internet example, a server 568 might transmit a requested code for an application program through Internet 566, ISP 564, local network 560 and communication interface 556.

The received code may be executed by processor 542 as it is received, and/or stored in storage device 548, or other non-volatile storage for later execution.

In some examples, values, procedures, or apparatuses are referred to as "lowest", "best", "minimum," or the like. It will be appreciated that such descriptions are intended to indicate that a selection among many used functional alternatives can be made, and such selections need not be better, smaller, or otherwise preferable to other selections. In addition, the values selected may be obtained by numerical or other approximate means and may only be an approximation to the theoretically correct/ value.

In one embodiment, a method for forming a volume reconstruction of a sample based on low resolution multi-energy image data comprises: receiving a plurality of multi-energy image data sets, each multi-energy data set of the plurality of multi-energy image data sets acquired of a different surface of a sample, wherein each multi-energy data set includes multiple images, each image of the multiple images acquired at a different beam energy, and wherein each image of the multiple images acquired include data from a different depth within the sample in relation to a respective surface of the different surfaces of the sample; and reconstructing, by an artificial neural network, a volume of the sample based on the plurality of multi-energy image data sets, wherein a resolution of the reconstruction is greater than a resolution of each image of the plurality of multi-energy image data sets. In a first example of the method, the method further includes wherein the artificial neural network is a three-dimensional artificial neural network. A second example of the method optionally includes the first example and further includes wherein the three-dimensional artificial neural network is selected from one of a 3D U-net, a volumetric convolutional neural network, a 3D Generative Adversarial Network, and combinations thereof. A third example of the method optionally includes one or more of the first and second examples, and further includes between acquiring sequential multi-energy data sets of the plurality of multi-energy image data sets, removing a slice of the sample to expose a subsequent surface of the different surfaces. A fourth example of the method optionally includes one or more of the first and third examples, and further includes, wherein removing a slice of the sample to expose a subsequent surface of the different surfaces includes removing, by a microtome, the slice of the sample to expose a subsequent surface of the different surfaces. A fifth example of the method optionally includes one or more of the first and fourth examples, and further includes, wherein the sample is a biological sample.

## Claims

1. An artificial intelligence reconstruction technique based on multi-energy data, the method comprising:
acquiring a first plurality of multi-energy images of a surface of a sample, each image of the first plurality of multi-energy images obtained at a different beam energy, wherein each image of the first plurality of multi-energy images include data from a different depth within the sample; and
reconstructing, by an artificial neural network, at least a volume of the sample based on the first plurality of multi-energy images, wherein a resolution of the reconstruction is greater than a resolution of the first plurality of multi-energy images.

2. The method of claim 1, wherein the artificial neural network is either a three-dimensional artificial neural network or is formed from a plurality of two-dimensional artificial neural networks.

3. The method of claim 2, wherein the three-dimensional artificial neural network is selected from one of a 3D U-net, a volumetric convolutional neural network, a 3D Generative Adversarial Network, and combinations thereof.

4. The method of claim 2, wherein the plurality of two-dimensional artificial neural networks reconstruct the volume of the sample based on the first plurality of multi-energy images, and wherein a different coordinate direction of the multi-energy image data is reconstructed by a different two-dimensional artificial neural network, and wherein the reconstructions of the different coordinate directions are reconstructed into the volume of the sample by a final two-dimensional artificial neural network.

5. The method of claim 4, further comprising:
removing a layer of the sample to expose a second surface; and
acquiring a second plurality of multi-energy images of the second surface of a sample, each image of the second plurality of multi-energy images obtained at a different beam energy, wherein each image of the second plurality of multi-energy images include data from a different depth within the sample.

6. The method of claim 5, wherein reconstructing, by an artificial neural network, at least a volume of the sample based on the first plurality of multi-energy images further includes
reconstructing, by the artificial neural network, at least a volume of the sample based on the first and second pluralities of multi-energy images.

7. The method of any one of claims 1-6, wherein the artificial neural network, prior to performing the reconstruction, is trained using a labeled version of the first plurality of multi-energy images.

8. The method of any one of claims 1-6, wherein the artificial neural network is trained using a third plurality of multi-energy images acquired of a second sample, and wherein, during the training, reconstructions generated by the artificial neural network are compared to high resolution slice and view data of a same volume of the second sample.

9. The method of claim 8, wherein the artificial neural network is further trained using a fourth plurality of multi-energy images, the fourth plurality of multi-energy images including images of a plurality of samples.

10. The method of any one of claims 1-6, wherein a charged-particle microscope both acquires the first plurality of multi-energy images, and reconstructs at least the volume of the sample using the artificial neural network.

11. A charged particle microscope system for obtaining volume reconstructions of a sample, the system including:
an electron beam for proving a beam of electrons at a plurality of different beam energies;
a cutting tool for removing a slice of a sample; and
a controller at least coupled to control the electron beam and the cutting tool, the controller including or coupled to a non-transitory computer readable medium storing code that, when executed by the controller or a computing system coupled to the controller, causes the system to:
acquire a first plurality of multi-energy images of a surface of a sample, each image of the first plurality of multi-energy images obtained at a different beam energy, wherein each image of the first plurality of multi-energy images include data from a different depth within the sample; and
reconstruct, by an artificial neural network coupled to or included in the system, at least a volume of the sample based on the first plurality of multi-energy images, wherein a resolution of the reconstruction is greater than a resolution of the first plurality of multi-energy images.

12. The system of claim 11, wherein the artificial neural network is a three-dimensional artificial neural network.

13. The system of claims 11 or 12, wherein the computer readable memory further includes code, that when executed, causes the system to:
remove, with the cutting tool, a layer of the sample to expose a second surface.

14. The system of claim 13, wherein the computer readable memory further includes code, that when executed, causes the system to:
acquire a second plurality of multi-energy images of the second surface of a sample, each image of the second plurality of multi-energy images obtained at a different beam energy, wherein each image of the second plurality of multi-energy images include data from a different depth within the sample; and
reconstruct, by the artificial neural network, at least a volume of the sample based on the first and second pluralities of multi-energy images.

15. The system of claims 11 or 12, wherein the artificial neural network, prior to performing the reconstruction, is trained using a labeled version of the first plurality of multi-energy images.
